(19) 

Europäisches Patentamt

European Patent Office

Office européen des brevets

(11) **EP 4 624 953 A1**

(12) **EUROPEAN PATENT APPLICATION**

(43) Date of publication:
   **01.10.2025 Bulletin 2025/40**

(21) Application number: **24165823.6**

(22) Date of filing: **25.03.2024**

(51) International Patent Classification (IPC):
   **G01R 31/367** (2019.01)     **G01R 31/3842** (2019.01)
   **G01R 31/392** (2019.01)     **G06N 3/08** (2023.01)
   **H02J 7/00** (2006.01)

(52) Cooperative Patent Classification (CPC):
   **G01R 31/367; G01R 31/3842; G01R 31/392;**
   **G06N 3/08; H02J 7/0048**

(84) Designated Contracting States:
   **AL AT BE BG CH CY CZ DE DK EE ES FI FR GB**
   **GR HR HU IE IS IT LI LT LU LV MC ME MK MT NL**
   **NO PL PT RO RS SE SI SK SM TR**
   Designated Extension States:
   **BA**
   Designated Validation States:
   **GE KH MA MD TN**

(71) Applicant: **Sonova AG**
   **8712 Stäfa (CH)**

(72) Inventor: **CHERIGUI, Fethi**
   **8134 Adliswil (CH)**

(74) Representative: **Sykora & König Patentanwälte**
   **PartG mbB**
   **Maximilianstraße 2**
   **80539 München (DE)**

(54) **DETERMINING PARAMETERS OF A RECHARGEABLE BATTERY OF A PORTABLE DEVICE**

(57)     A method for determining parameters (RCC, FCC, CCC) of a rechargeable battery (30) of a portable device (12) comprises: receiving a charge cycle number (CC) of the battery (30), a temperature (T) of the battery (30), a voltage (V) of the battery (30) and a current (I) of the battery (30); inputting the charge cycle number (CC), the temperature (T), the voltage (V) and the current (I) into a machine learning algorithm (38); and determining at least one of a residual charge capacity (RCC), a full charge capacity (FCC) and a Coulomb counter compensation (CCC) with the machine learning algorithm (38).

**Fig. 3**

**Description**

FIELD OF THE INVENTION

The invention relates to a method, computer program and computer-readable medium for determining parameters of a rechargeable battery of a portable device, for determining the state of charge and in particular the remaining operating time of the rechargeable battery as well as for training a machine learning algorithm used for determining the parameters. The invention further relates to a portable device.

BACKGROUND OF THE INVENTION

Portable devices, such as hearing devices and in particular hearing aids, are usually powered by rechargeable batteries. For a user, the battery state of health (SoH) and the battery state of charge (SoC) may be seen as the two most important parameters to be known.

The battery state of health defines the battery's ability to deliver the specified performance compared with a fresh battery. It takes into account such factors as charge acceptance, internal resistance, voltage and self-discharge. It is a measure of the long term capability of the battery and indicates how much of the available lifetime energy throughput of the battery has been consumed and how much is left.

The battery state of charge defines the amount of energy left in the battery compared with the energy it had when it was fully charged. This is the remaining capacity that defines the remaining runtime of the application together with the application load before it needs a recharging. It is a measure of the short term capability of the battery.

Most common state of the art SoC estimation methods used in practice are based on open circuit voltage estimation or current integration techniques with a Coulomb counter or both.

There are several factors affecting the SoC of a battery. For example, the voltage profile of a Lithium-ion battery, while being discharged, depends on the load current and temperature due to the internal impedance. The capacity at a given temperature reduces at higher load due to the internal impedance. It reduces as well for a given load at low temperature because the battery impedance increases.

Battery aging is another factor affecting the capacity. The latter declines as the number of charge and discharge cycles increase. This decline is quantified by the service life, defined as the number of charge/discharge cycles a battery can provide before its capacity falls to 80% of the initial value. The service life of a typical Lithium-ion battery is around 500 charge/discharge cycles.

Furthermore, self-discharge when the battery is not loaded is another factor affecting the SoC. Self-discharge is highly temperature-dependent and is larger when the internal impedance is low.

DESCRIPTION OF THE INVENTION

It is an objective of the invention to improve the state of charge estimation of a battery of a portable device.

This objective is achieved by the subject-matter of the independent claims. Further exemplary embodiments are evident from the dependent claims and the following description.

A first aspect of the invention relates to a method for determining parameters of a rechargeable battery of a portable device. These parameters may be used during a method for state of charge and/or state of health estimation of the rechargeable battery.

A portable device may be any device portable by a user, such as a smartphone, tablet computer, hearables, hearing devices, etc. The rechargeable battery powers the portable device with electric energy and/or is a part of the portable device. In general, the portable device may comprise a computing device with a processor and memory, which are powered by the rechargeable battery.

There may be a docking station adapted for charging the rechargeable battery to which the portable device can be mounted. When the portable device is mounted to the docking station, the rechargeable battery can be charged, while being part of the portable device.

During operation, i.e., when the rechargeable battery is discharging, and during charging, the portable device may determine the state of charge and/or may provide the state of charge to a user via a user display. The user can then decide, how much time is left for using the portable device, when the portable device has to be remounted to the charging station and when the portable device is ready for being reused. This may help the user for using the portable device.

In particular, battery issues are usually of high importance for hearing aid users in term of anxiety about the availability of the battery when they need it, as well as other issues like safety and reliability. By providing a trustful state of charge helps to relief the anxiety of an empty battery. In general, an accurate state of charge helps improving user experience, extend battery runtime and increase safety.

According to an embodiment, the method for determining parameters of the rechargeable battery comprises:

receiving a charge cycle number of the battery, a temperature of the battery, a voltage of the battery and a current of the battery; inputting the charge cycle number, the temperature, the voltage and the current into a machine learning algorithm; and determining at least one of a residual charge capacity, a full charge capacity and a Coulomb counter compensation with the machine learning algorithm.

The charge cycle number may be a counter, which is set to 0, when a new rechargeable battery is inserted into the portable device. Every time, when the rechargeable battery is charged, the counter may be increased by 1. The temperature, voltage and current may be sensed with a sensor of the portable device.

The charge cycle number, temperature, voltage and current are input values of a machine learning algorithm, which is run in the portable device and/or which determines the parameters of the rechargeable battery as output values, such as the residual charge capacity, the full charge capacity and the Coulomb counter compensation. As has been described above, these parameters of the rechargeable battery depend on the input values and therefore it is possible to train a machine learning algorithm to estimate these parameters.

The residual charge capacity (RCC) may be the capacity of the rechargeable battery, when a specific battery voltage has reached, indicating that the rechargeable battery is nearly empty. The voltage of the battery, i.e., the voltage across the terminals of the battery, depends on the state of charge of the battery and decreases while discharging. A specific voltage may be an indicator that the battery is nearly discharged, however, the residual charge capacity also depends on other conditions, such as the number of charging cycles and/or temperature.

The full charge capacity (FCC) may be the capacity of the battery, when it is completely charged. Also, the full charge capacity depends on conditions like charge cycle number, temperature, etc.

The Coulomb counter compensation (CCC), which also may be called Coulomb counter compensation factor, is a parameter and/or value, which may be used for compensating systematic measurement errors during Coulomb counting. With Coulomb counting, a remaining discharge capacity can be estimated by counting the capacity, i.e., the current integrated over time. Here, measurement errors with respect to the current, which may depend on the type of measurement and/or type of sensor, may be compensated with the Coulomb counter compensation.

According to an embodiment, the machine learning algorithm is an artificial neuronal network, in particular a multi-layer feed-forward neuronal network and/or a multi-layer-perceptron. It has been shown that rather small artificial neuronal networks are already able to estimate the parameters described above with enough accuracy. Furthermore, portable devices such as hearing devices may comprise hardware accelerators to perform artificial neuronal networks, which may be used for also performing the artificial neuronal network for determining the parameters of the rechargeable battery.

According to an embodiment, the artificial neuronal network comprises one input layer, one or two hidden layer and one output layer. The input layer may have one neuron per input value, i.e., charge cycle number, temperature, voltage and current. The output layer may comprise one neuron per output value, i.e., residual charge capacity, full charge capacity and Coulomb counter compensation. It has been shown that solely one hidden layer results in an artificial neuronal network estimating the parameters with high accuracy.

According to an embodiment, a number of neurons of hidden layers is less than 500, in particular less than 100. In particular, the artificial neuronal network may comprise solely one hidden layer with less than 500, in particular less than 100 neurons.

A further aspect of the invention relates to a method for determining the state of charge (SoC) of a rechargeable battery of a portable device. In the method, the parameters determined with the machine learning algorithm are used. It has to be noted that the three parameters, i.e., residual charge capacity, full charge capacity and Coulomb counter compensation, may be determined at different times and/or during different steps of the method. It may be that there is more than one machine learning algorithm, which are adapted for determining solely one or two of the three parameters. There may be one machine learning algorithm for determining the residual charge capacity, one for determining the full charge capacity and/or one for determining the Coulomb counter compensation. However, there may be a machine learning algorithm for determining all three parameters, for example a deep neuronal network algorithm used for multi-class classification problems.

The method for determining the state of charge may be performed by the portable device during charging and/or discharging, i.e., when it is operating in a normal mode. The method may be performed regularly, for example every second and/or in the range of minutes.

According to an embodiment, the method for determining the state of charge comprises: determining a remaining discharge capacity (RDC) by Coulomb counting. In Coulomb counting, the remaining discharge capacity at an actual time point is determined from the remaining discharge capacity at a previous time point plus a capacity offset. The capacity offset depends on an actual current of the battery, a time elapsed since the previous time point and parameters of the rechargeable battery, which have been determined with the method for determining parameters of the rechargeable battery, i.e., with the machine learning algorithm.

The remaining discharge capacity is determined iteratively. An actual current is measured regularly and per discrete integration, a capacity offset is determined. The capacity offset may be scaled by the parameters, such as residual charge capacity and/or full charge capacity. The capacity offset may be corrected with the Coulomb counter compensation. The capacity offset then may be added to the remaining discharge capacity at the previous time point to calculate the actual remaining discharge capacity.

According to an embodiment, the capacity offset depends on a difference of the full charge capacity and the residual charge capacity determined with the machine learning algorithm. In particular, the actual current times the time elapsed since the previous time point may be divided by the difference of the full charge capacity and the residual charge capacity.

According to an embodiment, additionally the Coulomb counter compensation offset determined with the machine learning algorithm is used to compensate for the coulomb counter current offset, hence, minimizing the state of charge (remaining discharge capacity or residual charge capacity) estimation error.

According to an embodiment, additionally the Coulomb counter compensation offset determined with the machine learning algorithm is added to the remaining discharge capacity. As already mentioned, this may compensate current systematic measurement errors.

According to an embodiment, the residual charge capacity is determined with the machine learning algorithm at a start of a charging cycle. It may be that the residual charge capacity is determined solely once in each charging cycle, i.e., when charging of the battery starts and/or when the battery is nearly empty.

According to an embodiment, the full charge capacity is determined with the machine learning algorithm at an end of a charging cycle. It may be that the full charge capacity is determined solely once in each charging cycle, i.e., when charging of the battery starts and/or when the battery is nearly empty.

According to an embodiment, a time to empty (TTE) is determined by dividing the remaining discharge capacity by the actual current of the battery and/or a time to full (TTF) is determined by subtracting the remaining discharge capacity from a difference of the full charge capacity and the residual charge capacity and dividing the result by the actual current of the battery. The time to empty and/or the time to full may be interesting values to be provided to the user, who then directly knows, when he has to recharge his or her portable device and/or when charging will end.

According to an embodiment, the method further comprises: providing the state of charge, the time to empty and/or the time to full with a user interface of the portable device to the user. The user interface may be an acoustic user interface, when the portable device is a hearing device, such as hearables or a hearing aid. It may be that such a portable device is in data communication with a further portable device having a display, such as a smartphone. In the case, when the portable device has a display, the user interface may be a graphical user interface showing the respective value, i.e., the state of charge, the time to empty and/or the time to full.

A further aspect of the invention relates to a portable device comprising a rechargeable battery and sensors for determining input values of the machine learning algorithm such as a temperature sensor for sensing the temperature of the battery, a voltage sensor for sensing the voltage of the battery and a current sensor for sensing the current of the battery. The portable device furthermore comprises a battery management system adapted for performing the method, such as described herein.

According to an embodiment, the portable device is a hearing device, in particular a hearing aid. A hearing device may be a device to be worn in and/or on an ear of the user and for providing sound into the ear channel of the user. A hearing aid may be a device for compensating a hearing loss of the user. The hearing device may comprise a microphone for acquiring environmental sound, a sound processor for modifying the sound signal acquired by the microphone and a loudspeaker for outputting the modified sound to the user. For hearing aids, it is very important for the user to know how long the hearing aid is still operating and when it has to be recharged, since it may be possible that the user is not able to live his or her daily life without the aid of the device.

According to an embodiment, the battery is a Lithium-ion battery. The charging state of Lithium-ion batteries strongly depends on the charging cycle number and temperature and continuously depends on the actual current and voltage. Thus, the parameters mentioned above may be estimated by a machine learning algorithm.

A further aspect of the invention relates to a training method for training a machine learning algorithm for determining parameters of a rechargeable battery of a portable device. The training method may be performed at a manufacture of the portable device. The machine learning algorithm may comprise weights, from which the output is calculated. Training may include determining these weights.

According to an embodiment, the training method comprises: receiving a dataset with records of a plurality of rechargeable batteries of the same type, each record comprising a charge cycle number, a battery temperature, a battery voltage, a battery current and at least one of a residual charge capacity, a full charge capacity and a Coulomb counter compensation; and training the machine learning algorithm with the dataset. Such a dataset may be collected by a manufacturer of the portable device. During manufacturing, the trained machine learning algorithm and/or its weights may be stored in the portable device.

According to an embodiment, the residual charge capacity and the full charge capacity are determined by open circuit measurements. For determining the parameters of the rechargeable battery, which are included into the training data set and/or which are used for training the machine learning algorithm, open circuit measurements may be performed, i.e., these parameters may be measured and/or determined for a battery disconnected from the portable device.

A further aspect of the invention relates to a computer program for determining parameters of a rechargeable battery of a portable device with a machine learning algorithm, for determining the state of charge of the rechargeable battery and/or for training the machine learning algorithm, which, when being executed by a processor, is adapted to carry out the steps of the method as described in the above and in the following. For example, the computer program for determining the parameters may be executed in the portable device. The computer program for training the machine learning algorithm may be executed in a computing device of a hearing device manufacture.

It also may be possible that the method for determining the parameters of the rechargeable battery is at least partially run in hardware, in particular a neural processor and/or accelerator. Such a hardware component already may be present in the portable device and may be used for further tasks, such as classifying an audio signal acquired with the portable device, such as a hearing device. This classification may be performed with an artificial neuronal network, which is run in the neural processor and/or accelerator.

A further aspect of the invention relates to a computer-readable medium, in which such a computer program is stored. The computer-readable medium may be a memory of the respective device, such as the portable device. In general, a computer-readable medium may be a hard disk, an USB (Universal Serial Bus) storage device, a RAM (Random Access Memory), a ROM (Read Only Memory), an EPROM (Erasable Programmable Read Only Memory) or a FLASH memory. A computer-readable medium may also be a data communication network, e.g., the Internet, which allows downloading a program code. The computer-readable medium may be a non-transitory or transitory medium.

It has to be understood that features of the method as described in the above and in the following may be features of the computer program and the computer-readable medium as described in the above and in the following, and vice versa.

These and other aspects of the invention will be apparent from and elucidated with reference to the embodiments described hereinafter.

BRIEF DESCRIPTION OF THE DRAWINGS

Below, embodiments of the present invention are described in more detail with reference to the attached drawings.

Fig. 1 schematically shows a portable device system with a portable device according to an embodiment of the invention.

Fig. 2 shows a flow diagram for a method for determining the state of charge of a rechargeable battery according to an embodiment of the invention.

Fig. 3 illustrates an artificial neuronal network used in the method of Fig. 2.

The reference symbols used in the drawings, and their meanings, are listed in summary form in the list of reference symbols. In principle, identical parts are provided with the same reference symbols in the figures.

DETAILED DESCRIPTION OF EXEMPLARY EMBODIMENTS

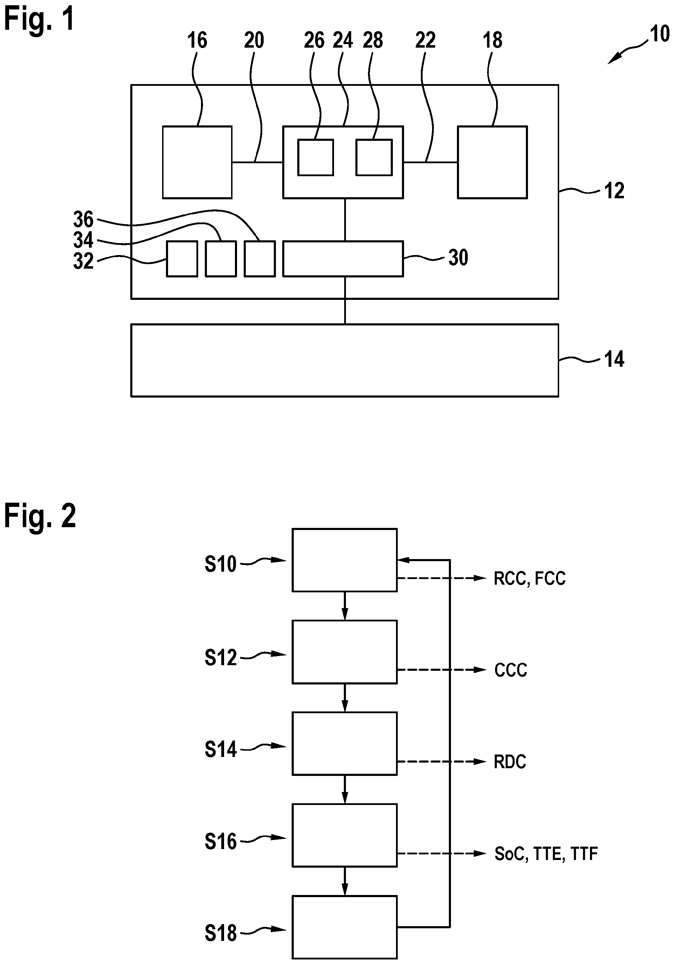

Fig. 1 shows a portable device system 10 comprising a portable device 12 and a charging station 14. In the following, the portable device 12 will be described in an exemplary way as hearing device 12 and the portable device system 10 may be seen as hearing device system 10 in this case. However, it has to be understood that in the following, the hearing device 12 may be considered more general as portable device, such as tablet computer, smartphone, music player, etc.

Specifically, the hearing device 12 may be a hearing aid, for example, a behind-the-ear device or an in-the ear device carried by a user.

The hearing device 12 comprises a microphone 16 and a sound output device 18, such as a loudspeaker. The microphone 16 can detect a sound in the environment of the user and generate an audio signal 20 indicative of the detected sound. The sound output device 18 can output sound based on the audio signal 20 modified into a processed audio signal 22 by the hearing device 12. The sound may then be guided into the ear channel of the user.

For modifying the sound signal 20, the hearing device 12 comprises a processor 24, which is configured to receive the audio signal 20 generated by the microphone 16. Sound processing may be done by a sound processing module 26, which may be implemented as a computer program and/or software executed by the processor 24, which may comprise a CPU for processing the computer program. As an alternative, the sound processing module 26 may comprise a sound processor implemented in hardware or more specific a DSP (digital signal processor) for modifying the audio signal 20.

The sound processing module 26 may be configured to modify, in particular amplify, dampen and/or delay, the audio signal 20 generated by the microphone 16 to generate the processed audio signal 22. The sound processing module 26 may modify some frequencies or frequency ranges of the audio signal 20 depending on parameter values of parameters stored in the hearing device 12, which influence the amplification, the damping and/or, respectively, the delay.

It may be that the hearing device 12 comprises a neural processor and/or accelerator 28. The neural processor 28 may be implemented as a computer program and/or software executed by the processor 24. As an alternative, the neural processor 28 may be implemented in hardware. The neural processor 28 is adapted for processing and/or providing one or more artificial neuronal networks, which are adapted for classifying the sound signal 20, for example for discriminating, whether there is speech in the sound signal, etc. Such a classification may be used for selecting sound programs of the hearing device 12, which result in different sound processing of the sound signal 20.

The hearing device 12 comprises a battery 30, for example a Lithium-ion battery, which supplies the hearing device 12 and in particular the component 16, 18, 24 with electrical power. The hearing device 12 comprises several sensors 32, 34, 36 for determining the state of the battery 30. A voltage sensor 32 measures the voltage across the battery 30. A current sensor 34 measures the current through the battery 30. A temperature sensor 36 measures the temperature of the battery 30. All these measurements will be used for determining the state of charge of the battery 30, such as described herein.

For charging the battery 30, the hearing device 12 may be put on the charging station 14, which then supplies the battery 30 with electrical power. Charging may be controlled based on the measurements performed by the sensors 32, 34, 36.

Fig. 2 shows a flow diagram for a method for determining the state of charge SoC of the rechargeable battery 30 of the portable device 12. The method may be performed automatically by an embedded software component of the portable device 12. The method is repeated periodically and is performed continuously during charge and discharge cycles of the battery 30 at a certain rate, for example in the range of seconds or minutes.

The charging of the battery 30 may be performed by another method and/or embedded software component of the portable device 12. For example, when the portable device 12 is in the charging station 14 and when the battery voltage V is below a lower threshold, charging may start. When the battery voltage V has reached an upper threshold, charging may stop.

In step S10 of the method of Fig. 2 it is determined, whether the battery 30 is charging or discharging. This may be determined by measuring the current I and/or voltage V with the sensors 32, 34. Discrimination between charging and discharging can be made based on a sign of the current I and/or voltage V.

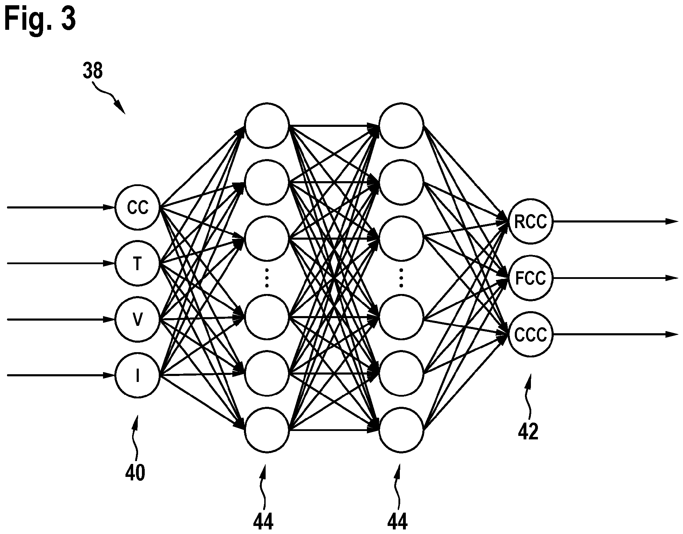

It is determined, whether the battery 30 is empty. This may be the case, when the battery voltage V is below a lower threshold, such as 3.2V. When the battery 30 is empty and/or the battery voltage V is below the lower threshold, it may be assumed that the method is at the start of a charging cycle. In this case, the residual charge capacity RCC of the battery 30 is recalibrated and/or determined with a machine learning algorithm 38. The determination of parameters of the battery 30 with a machine learning algorithm 38 is described with respect to Fig. 3 in more detail.

In step S10, it is also determined, whether the battery is full. This may be the case, when the battery voltage V is above an upper threshold, such as 4.2V. When the battery 30 is full and/or the battery voltage V is above the upper threshold, it may be assumed that the method is at the end of a charging cycle. In this case, the full charge capacity FCC of the battery 30 is recalibrated and/or determined with the machine learning algorithm 38.

The battery parameters RCC and FCC, which will be used below for calculating the state of charge SoC of the battery 30, are not constant and change based on the aging of the battery, which may be estimated from the charge cycle number, and the temperature. Thus, they need to be calibrated regularly.

In step S12, the battery current I of the battery 30, which may be the charge current or the discharge current, is measured with the sensor 34 and monitored.

A Coulomb counter compensation CCC is determined. The Coulomb counter compensation CCC is needed for compensating systematic measurement errors of voltage and current, which will influence the Coulomb counting in the next method step. In particular, the integrated current over time may be subject to an offset due to a measurement circuit inaccuracy. A recalibration to compensate for the accumulated offset may be needed.

The Coulomb counter compensation CCC may be determined with the machine learning algorithm 38, such as described with respect to Fig. 3.

In the case of charging, when the charging current I is constant, it also may be possible that a constant Coulomb counter compensation CCC is used.

In step S14, a remaining discharge capacity RDC of the battery 30 is determined by Coulomb counting.

Coulomb counting is based on integration of the measured current I, which is charged over time, when the battery 30 is charging or discharging. A real time counter may provide the timing base for integrating the current I. The accumulated charge will be positive while charging or negative while discharging. Measuring the current I over a given time step $\Delta t$ reflects the capacity that has left or has been received by the battery 30.

In particular, the remaining discharge capacity RDC is calculated by

$$RDC(t) = RDC(t-1) + \frac{I(t)}{FCC - RCC} \Delta t + CCC \qquad (1)$$

where

- $RDC(t)$ is the estimated remaining discharge capacity at the actual time point $t$
- $RDC(t-1)$ is the estimated remaining discharge capacity at the previous time point $t$-1
- $I(t)$ is the charging (positive) or discharging (negative) current at time $t$
- $FCC$ is the full charge capacity from step S10
- $RCC$ is the residual charge capacity from step S10
- CCC is the Coulomb counter compensation from step S12
- $\Delta t$ is the time step between $t$-1 and $t$

Coulomb counting gives a relative change in the remaining discharge capacity RDC and not an absolute remaining discharge capacity RDC. For the absolute remaining discharge capacity RDC(t), the previous remaining discharge capacity RDC(t-1) as given in equation (1) needs to be known. The initial remaining discharge capacity RDC(0) may be reset, when the battery 30 is fully charged or empty.

From equation (1) it can be seen that the remaining discharge capacity RDC at an actual time point t is determined from the remaining discharge capacity RDC at a previous time point t-1 plus a capacity offset, which capacity offset depends on an actual current of the battery 30, a time elapsed since the previous time point t-1 and the parameters RCC, FCC, CCC of the rechargeable battery 30.

The capacity offset depends on a difference of the full charge capacity FCC and the residual charge capacity RCC and in particular has a summand, which is the actual current I divided by the difference and multiplied with the time step $\Delta t$, i.e., the length of the time period between the actual time point t and the previous time point t-1.

A further summand of the capacity offset is the Coulomb counter compensation CCC, which is also added to the previous remaining discharge capacity RDC(t-1).

In step S16, values indicative of the charging and/or discharging state are calculated. The values may comprise at least one of the state of charge SoC, time to empty TTE and time to full TTF. All these values are calculated from the remaining discharge capacity RDC.

$$SoC(t) = \frac{RDC(t)}{FCC - RCC} \quad (2)$$

$$TTE(t) = \frac{RDC(t)}{I(t)} \qquad (3)$$

$$TTF(t) = \frac{(FFC - RCC) - RDC(t)}{I(t)} \qquad (4)$$

where:

- $SoC(t)$ is the estimated state of charge at time t as percentage value
- $TTE(t)$ is the estimated time to empty at time $t$
- $TTF(t)$ is the estimated time to full at time $t$

The percentage state of charge SoC is the remaining discharge capacity RDC divided by the difference of the full charge capacity FCC and the residual charge capacity RCC.

The time to empty TTE is determined by dividing the remaining discharge capacity RDC by the actual current I of the battery 30.

The time to full TTF is determined by subtracting the remaining discharge capacity RDC from the difference of the full charge capacity FCC and the residual charge capacity RCC and dividing the result by the actual current of the battery 30.

The time to empty TTE solely may be determined during discharging and the time to full TTF solely may be determined during charging of the battery 30.

In step S18, the state of charge SoC, the time to empty TTE and/or the time to full TTF are provided with a user interface of the portable device 12 to the user. The user interface may be an acoustic user interface, when the portable device 12 is a hearing device. It may be that the portable device 12 is in data communication with a further portable device having a display, such as a smartphone. In the case, when the portable device 12 has a display, the user interface may be a graphical user interface showing the respective value, i.e., the state of charge SoC, the time to empty TTE and/or the time to full TTF.

In step S18, data logging also may be done periodically to store parameters of the battery 30, like the residual charge capacity RCC and the full charge capacity FCC, and values calculated therefrom like the residual charge capacity RCC. The data may be logged and/or stored in a non-volatile memory of the portable device 12. Data logging may be performed, because the portable device 12 may be turned off or the battery 30 can get empty. After such an event, the logged data may be loaded again from the non-volatile memory.

Fig. 3 illustrates a machine learning algorithm 38, which is used to recalibrate the parameters RCC, FCC and CC of the Coulomb counter. The machine learning algorithm 38 as shown in Fig. 3 is an artificial neuronal network and in particular a multi-layer feed-forward neuronal network and/or a multi-layer-perceptron. A multi-layer perceptron (MLP) is suitable for regression prediction problems, where a real-valued quantity is predicted given a set of inputs. MLPs are suitable for classification prediction problems where inputs are assigned a class or label. Furthermore, MLP classifiers can handle various types of data. They can also accommodate multiple output classes, making them suitable for multi-class classification problems.

The artificial neuronal network 38 comprises one input layer 40 and one output layer 42. The input layer 40 has one neuron per input value, i.e., charge cycle number CC, temperature T, voltage V and current I. The output layer 42 has one neuron per output value, i.e., residual charge capacity RCC, full charge capacity FCC and Coulomb counter compensation CCC. The artificial neuronal network 38 may comprise one or two hidden layers 44. It has been shown that the number of neurons of the hidden layers 44 may be less than 500, in particular less than 100 neurons, for accurately determining the parameters RCC, FCC and CCC.

Each layer 44, 42 processes the information from the previous layer and sends the results to the next layer. Generally, a three-layer neural network 38 may approximate the nonlinear mapping with arbitrary precision.

With the artificial neuronal network 38, a method for determining the parameters RCC, FCC, CCC of the rechargeable battery 30 may be performed. The artificial neuronal network 38 may be implemented as a software component of the portable device 12, however also may be at least partially implemented in hardware, such as with a neural processor and/or accelerator 28.

The method starts by receiving the charge cycle number CC of the battery 30, a temperature T of the battery 30, a voltage V of the battery 30 and a current I of the battery 30, such as determined in the method of Fig. 2. The charge cycle number CC, the temperature T, the voltage V and the current I are input into the input layer 40 of artificial neuronal network 38, which then determines at least one of a residual charge capacity RCC, a full charge capacity FCC and a Coulomb counter compensation CCC, which one or more parameters are output by the output layer 42.

In the example of Fig. 3, there are one input layer 40 with 4 neurons, two hidden layers 33 and one output layer 42 with 3 output neurons. The number of neurons of the two hidden layers 44 may be determined before the training of the artificial neuronal network 38. This number depends on the required accuracy.

The artificial neuronal network 38 may be trained offline and the resulting weights may be stored in a non-volatile memory of the portable device 12. During the training, a dataset with records of a plurality of rechargeable batteries 30 of the same type may be determined and then received in a training algorithm. Each record comprises the charge cycle number CC, the battery temperature T, the battery voltage V, the battery current I and at least one of a residual charge capacity RCC, a full charge capacity FCC and a Coulomb counter compensation CCC for differently aged batteries at different temperatures and different charging and discharging states of the batteries. The artificial neuronal network 38 is then trained with the training algorithm based on the dataset.

The training dataset may be based on experimental dataset from battery and Coulomb counter characterizations over temperature T and charge cycle number CC during a charge cycle. The RCC and FFC characterization over temperature T and charge cycle number CC during a charge cycle may be measured with open circuit measurements, with or without relaxation. Temperature T and voltage V may be measured for that. Also, the characterization of the Coulomb counter current drift over time versus discharge rate is included into the dataset. The current I may be measured for that. This may be decoupled from the charge or discharge cycles.

For the training, the measured data may be used as input directly or extracted features (for example smoothed using filtering) are used. The correlation between these feature values and characterized CCC, RCC and FCC is used to select the feature values with highest correlation coefficient, which are the input of the artificial neuronal network 38. A supervised learning using labeled datasets to train the artificial neuronal network 38 may be performed. The weights of the artificial neuronal network 38 may be adjusted until the artificial neuronal network 38 has been fitted appropriately to reproduce the output parameters RCC, FFF and CCC.

While the invention has been illustrated and described in detail in the drawings and foregoing description, such

# EP 4 624 953 A1

illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfill the functions of several items recited in the claims. The mere fact that certain measures are recited in mutually different dependent claims does not indicate that a combination of these measures cannot be used to advantage. Any reference signs in the claims should not be construed as limiting the scope.

LIST OF REFERENCE SYMBOLS

| | |
|---|---|
| 10 | portable device system / hearing device system |
| 12 | portable device / hearing device |
| 14 | charging station |
| 16 | microphone |
| 18 | sound output device |
| 20 | audio signal |
| 22 | processed audio signal |
| 24 | processor |
| 26 | sound processing module |
| 28 | neural processor/ accelerator |
| 30 | battery |
| 32 | voltage sensor |
| 34 | current sensor |
| 36 | temperature sensor |
| 38 | machine learning algorithm / artificial neuronal network |
| 40 | input layer |
| 42 | output layer |
| 44 | hidden layer |
| CC | charge cycle number |
| T | temperature |
| V | voltage |
| I | current |
| SoC | state of charge |
| RCC | residual charge capacity |
| FCC | full charge capacity |
| CCC | Coulomb counter compensation |
| RDC | remaining discharge capacity |
| TTE | time to empty |
| TTF | time to full |

**Claims**

1. A method for determining parameters (RCC, FCC, CCC) of a rechargeable battery (30) of a portable device (12), the method comprising:

   receiving a charge cycle number (CC) of the battery (30), a temperature (T) of the battery (30), a voltage (V) of the battery (30) and a current (I) of the battery (30);
   inputting the charge cycle number (CC), the temperature (T), the voltage (V) and the current (I) into a machine learning algorithm (38);
   determining at least one of a residual charge capacity (RCC), a full charge capacity (FCC) and a Coulomb counter compensation (CCC) with the machine learning algorithm (38).

2. The method of claim 1,
   wherein the machine learning algorithm (38) is an artificial neuronal network, a multi-layer feed-forward neuronal network and/or a multi-layer-perceptron.

9

**3.** The method of claim 2,

wherein the artificial neuronal network (38) comprises one input layer (40), one or two hidden layers (44) and one output layer (42); and/or
wherein a number of neurons of the hidden layers (44) is less than 500.

**4.** A method for determining the state of charge (SoC) of a rechargeable battery (30) of a portable device, the method comprising:

determining a remaining discharge capacity (RDC) by Coulomb counting, wherein the remaining discharge capacity (RDC) at an actual time point is determined from the remaining discharge capacity (RDC) at a previous time point plus a capacity offset, which capacity offset depends on an actual current of the battery (30), a time elapsed since the previous time point and parameters (RCC, FCC, CCC) of the rechargeable battery (30);
wherein the parameters of the rechargeable battery (30) are determined with the method of one of claims 1 to 3.

**5.** The method of claim 4,
wherein the capacity offset depends on a difference of the full charge capacity (FCC) and the residual charge capacity (RCC) determined with the machine learning algorithm (38).

**6.** The method of one of the previous claims,
wherein additionally the Coulomb counter compensation (CCC) determined with the machine learning algorithm (38) is used to compensate a coulomb counter current offset.

**7.** The method of one of claims 4 to 6,

wherein the residual charge capacity (RCC) is determined with the machine learning algorithm (38) at a start of a charging cycle; and/or
wherein the full charge capacity (FCC) is determined with the machine learning algorithm (38) at an end of a charging cycle.

**8.** The method of one of claims 4 to 7,

wherein a time to empty (TTE) is determined by dividing the remaining discharge capacity (RDC) by the actual current of the battery (30); and/or
wherein a time to full (TTF) is determined by subtracting the remaining discharge capacity (RDC) from a difference of the full charge capacity (FCC) and the residual charge capacity (RCC) and dividing the result by the actual current of the battery (30).

**9.** The method of claim 8, further comprising:
providing the state of charge (SoC), the time to empty (TTE) and/or the time to full (TTF) with a user interface of the portable device (12) to the user.

**10.** A portable device (12), comprising:

a rechargeable battery (30);
a temperature sensor (36) for sensing the temperature (T) of the battery (30);
a voltage sensor (32) for sensing the voltage of the battery (30);
a current sensor (34) for sensing the current of the battery (30);
wherein the portable device (12) is adapted for performing the method of one of the previous claims.

**11.** The portable device (12) of claim 10,

wherein the portable device (12) is a hearing device; and/or
wherein the battery (30) is a Lithium-ion battery.

**12.** A training method for training a machine learning algorithm (38) for determining parameters of a rechargeable battery (30) of a portable device (12), the training method comprising:

receiving a dataset with records of a plurality of rechargeable batteries (30) of the same type, each record comprising a charge cycle number (CC), a battery temperature (T), a battery voltage (V), a battery current (I) and at least one of a residual charge capacity (RCC), a full charge capacity (FCC) and a Coulomb counter compensation (CCC);

training the machine learning algorithm (38) with the dataset.

13. The training method of claim 12,
    wherein the residual charge capacity (RCC) and the full charge capacity (FCC) are determined by open circuit measurements.

14. A computer program for determining parameters (RCC, FCC, CCC) of a rechargeable battery (30) of a portable device (12) with a machine learning algorithm (38), for determining the state of charge (SoC) of the rechargeable battery (30) and/or for training the machine learning algorithm (38), which, when being executed by a processor, is adapted to carry out the steps of the method of one of claims 1 to 9 and 12 to 13.

15. A computer-readable medium, in which a computer program according to claim 14 is stored.

**Fig. 1**

**Fig. 2**

S10 — RCC, FCC

S12 — CCC

S14 — RDC

S16 — SoC, TTE, TTF

S18

**Fig. 3**

38

40

CC

T

V

I

44

44

RCC

FCC

CCC

42

Europäisches
Patentamt

European
Patent Office

Office européen
des brevets

# EUROPEAN SEARCH REPORT

**Application Number**

EP 24 16 5823

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/213585 A1 (SHIMAWAKI HIDENORI [JP] ET AL) 6 July 2023 (2023-07-06) * abstract; claims 1-22; figures 1-14 * * paragraph [0008] - paragraph [0052] * * paragraph [0069] - paragraph [0138] * | 1-3, 10-15 | INV. G01R31/367 G01R31/3842 G01R31/392 G06N3/08 H02J7/00 |
| X | US 2018/306868 A1 (KIM KWANG SUN [KR] ET AL) 25 October 2018 (2018-10-25) * abstract; claims 1-13; figures 1-16 * * paragraph [0016] - paragraph [0031] * * paragraph [0052] - paragraph [0200] * | 1-3, 10-15 | |
| X | CN 115 856 641 A (ZHANGYU BOSHI INTELLIGENT TECH SHANGHAI CO LTD) 28 March 2023 (2023-03-28) * the whole document * | 1-3, 10-15 | |
| X | HOW DICKSHON N T ET AL: "State-of-Charge Estimation of Li-Ion Battery in Electric Vehicles: A Deep Neural Network Approach", IEEE TRANSACTIONS ON INDUSTRY APPLICATIONS, IEEE SERVICE CENTER, PISCATAWAY, NJ, US, vol. 56, no. 5, 22 June 2020 (2020-06-22), pages 5565-5574, XP011809470, ISSN: 0093-9994, DOI: 10.1109/TIA.2020.3004294 [retrieved on 2020-09-17] * the whole document * | 1-15 | **TECHNICAL FIELDS SEARCHED (IPC)** G01R H02J G06N |
| A | US 2021/005939 A1 (TAJIMA RYOTA [JP] ET AL) 7 January 2021 (2021-01-07) * abstract; claims 1-6; figures 1A-14D * * paragraph [0012] - paragraph [0036] * * paragraph [0052] - paragraph [0148] * | 1-15 | |

The present search report has been drawn up for all claims

| Place of search | Date of completion of the search | Examiner |
|---|---|---|
| Munich | 9 September 2024 | Nadal, Rafael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                     EP 24 16 5823

This annex lists the patent family members relating to the patent documents cited in the above-mentioned European search report.
The members are as contained in the European Patent Office EDP file on
The European Patent Office is in no way liable for these particulars which are merely given for the purpose of information.

09-09-2024

| Patent document cited in search report | Publication date | Patent family member(s) | | Publication date |
|---|---|---|---|---|
| US 2023213585 A1 | 06-07-2023 | CN | 115698738 A | 03-02-2023 |
| | | EP | 4160784 A1 | 05-04-2023 |
| | | JP | 7457575 B2 | 28-03-2024 |
| | | JP | 2021185354 A | 09-12-2021 |
| | | US | 2023213585 A1 | 06-07-2023 |
| | | WO | 2021241115 A1 | 02-12-2021 |
| US 2018306868 A1 | 25-10-2018 | KR | 101792975 B1 | 02-11-2017 |
| | | US | 2018306868 A1 | 25-10-2018 |
| | | WO | 2018199434 A1 | 01-11-2018 |
| CN 115856641 A | 28-03-2023 | NONE | | |
| US 2021005939 A1 | 07-01-2021 | JP | 7104065 B2 | 20-07-2022 |
| | | JP | 2022141752 A | 29-09-2022 |
| | | JP | WO2019116145 A1 | 21-01-2021 |
| | | US | 2021005939 A1 | 07-01-2021 |
| | | US | 2023132746 A1 | 04-05-2023 |
| | | WO | 2019116145 A1 | 20-06-2019 |

EPO FORM P0459

For more details about this annex : see Official Journal of the European Patent Office, No. 12/82